# EUROPÄISCHE PATENTSCHRIFT

(11) **EP 4 115 519 B1**
(45) Veröffentlichungstag und Bekanntmachung des Hinweises auf die Patenterteilung: **27.09.2023**
(21) Anmeldenummer: 21719039.6
(22) Anmeldetag: 04.03.2021
(51) Int. Cl.: H02S 40/34, H01L 31/048

(54) **BIFAZIAL-SOLARMODUL**
BIFACIAL SOLAR MODULE
MODULE SOLAIRE BIFACIAL

(30) Priorität: 06.03.2020 DE 102020106189
(43) Veröffentlichungstag der Anmeldung: 11.01.2023
(73) Patentinhaber: Hanwha Q CELLS GmbH, 06766 Bitterfeld-Wolfen (DE)
(72) Erfinder: OTTO, Silke, 06766 Bitterfeld-Wolfen (DE)
(74) Vertreter: adares Patent- und Rechtsanwälte Reininger & Partner GmbB
(86) Internationale Anmeldenummer: PCT/DE2021/100221
(87) Internationale Veröffentlichungsnummer: WO 2021/175380

(56) Entgegenhaltungen:
- EP-A1- 2 672 527
- EP-A1- 3 379 582
- EP-A2- 2 610 916
- AU-B2- 608 701
- CN-U- 206 060 677
- KR-A- 20160 116 745
- MADON FRÉDÉRIC ET AL: "Bifacial NICE Modules from High Efficiency n-type BiSoN Solar Cells", ENERGY PROCEDIA, Bd. 77, August 2015 (2015-08), Seiten 382-385, XP055804490, NL ISSN: 1876-6102, DOI: 10.1016/j.egypro.2015.07.053
- Podlowski Lars: "Bifacial PV Technology Ready for Mass Deployment", White Paper, 2019, Seiten 1-9, XP055807475, Gefunden im Internet: URL:https://www.pi-berlin.com/wp-content/u ploads/2019/10/White-Paper-Bifacial-PV-Tec hnology-PI-Berlin.pdf [gefunden am 2021-05-26]

## Beschreibung

Die Erfindung betrifft ein Bifazial-Solarmodul. Insbesondere betrifft die Erfindung ein Bifazial-Solarmodul mit einer Frontseitenoberfläche und einer Rückseitenoberfläche, aufweisend ein die Frontseitenoberfläche des Solarmoduls bildendes Frontseitenverkapselungselement, eine Mehrzahl Solarzellen, die elektrisch miteinander verschaltet sind, ein die Rückseitenoberfläche des Solarmoduls mit einer Rückseitenoberflächenebene bildendes Rückseitenverkapselungselement, und mindestens eine Junction-Box, die zumindest teilweise auf der Rückseitenoberfläche angeordnet ist und ein Gehäuse aufweist.

Ein Bifazial-Solarmodul besitzt die Eigenschaft, sowohl auf die Frontseitenoberfläche einfallendes Licht als auch auf die Rückseitenoberfläche einfallendes Licht zur Stromerzeugung zu nutzen. Bei dem Bifazial-Solarmodul wird eine für sichtbares Licht transparente Folie oder ein entsprechendes Glas als Rückseitenverkapselungselement verwendet. So kann Licht, das ohne absorbiert zu werden durch das Solarmodul tritt und reflektiertes Licht aus der Umgebung der Solarmodule, das auf die Rückseiten der Solarzellen trifft, ebenfalls genutzt werden. Ein Monofazial-Solarmodul kann hingegen nur auf die Vorderseite einfallendes Licht zur Stromerzeugung nutzen. Bei dem Monofazial-Solarmodul wird anders als beim vorliegenden Bifazial-Solarmodul ein lichtundurchlässiges oder stark lichtabsorbierendes Rückseitenverkapselungselement verwendet.

Das Bifazial-Solarmodul ist daher ein Solarmodul, das Sonnenlicht von zwei Seiten ausnutzen kann. Dadurch, dass das Bifazial-Solarmodul nicht nur einen direkten Lichteinfall über die Frontseitenoberfläche sondern auch einen indirekten Lichteinfall über die Rückseitenoberfläche verwerten kann, wird ein höherer Wirkungsgrad erzielt als bei einem Monofazial-Solarmodul. So kann zum Beispiel ein von einer hellen Hauswand zurückgeworfenes Licht von der Rückseite des Bifazial-Solarmoduls genutzt werden. Jedoch besteht weiterhin ein Bedarf an einer Optimierung des Wirkungsgrads von Bifazial-Solarmodulen.

EP 2 610 916 A2 beschreibt ein oben beschriebenes Bifazial-Solarmodul. Um ein Verschattungsproblem der Rückseitenoberfläche zu reduzieren oder zu vermeiden und so den Wirkungsgrad zu erhöhen, wird die Junction-Box verkleinert und/oder an einem Randbereich angeordnet. EP 3 379 582 A1 beschreibt ebenfalls ein Bifazial-Solarmodul, das eine Junction-Box aufweist, die in einem Randbereich angeordnet ist.

Podlowski Lars: in "Bifacial PV Technology Ready for Mass Deployment", White Paper, 2019, S. 1-9, schlagen zur Erhöhung des Wirkungsgrads vor, anstelle einer Junction-Box einer ersten Größe auf der Rückseitenoberfläche drei Junction-Boxen einer zweiten Größe in einem Randbereich des Solarmoduls anzuordnen, wobei die zweite Größe kleiner ist als erste Größe.

KR 2016 0116745 A beschreibt ein Bifazial-Solarmodul, das eine Junction-Box aufweist, auf der ein Reflektor angebracht ist.

Madon Frederic ET AL: "Bifacial NICE Modules from High Efficiency n-type BiSoN Solar Cells", Energy Procedia, Bd. 77, August 2015, S. 382-385 und AU 608 701 B2 beschreiben jeweils Bifazial-Solarmodule, bei denen die Junction-Box an sich zwischen der Frontseitenoberfläche und Rückseitenoberfläche erstreckenden Kanten des Solarmoduls angebracht ist, um die Verschattung der Front- und Rückseitenoberfläche zu verringern.

CN 206 060 677 U beschreibt ein Solarmodul mit einer Junction-Box und einem transparenten Deckel, der eine leichtere Inspektion des Innenraums der Junction-Box ermöglicht.

EP 2 672 527 A1 beschreibt ein Solarmodul mit einem Rückseitenverkapselungselement und einer Steckeinrichtung, die teilweise in eine Öffnung des Rückseitenverkapselungselements einlaminiert ist.

Es besteht weiterhin ein Bedarf an einer Optimierung des Wirkungsgrads von Bifazial-Solarmodulen.

Es ist eine Aufgabe der Erfindung, ein Bifazial-Solarmodul mit einem noch weiter verbesserten Wirkungsgrad bereitzustellen.

Erfindungsgemäß wird die Aufgabe durch ein Bifazial-Solarmodul mit den Merkmalen nach Anspruch 1 gelöst. Vorteilhafte Weiterbildungen und Modifikationen sind in den Unteransprüchen angegeben.

Erfindungsgemäß ist vorgesehen, dass das Gehäuse der Junction Box aus einem im Wellenlängenbereich von 380nm bis 1100nm optisch transparenten Material ausgebildet ist.

Eine Junction-Box, auch als Anschlussdose bezeichnet, ist üblicherweise aus schwarzem Kunststoff-Material ausgebildet. Dadurch reduziert sie jedoch durch die Material-bedingte partielle Abschattungen auf der Rückseitenoberfläche eine optimale (Licht-)Ausbeute und vermindert dadurch den Wirkungsgrad des Solarmoduls. Durch eine transparent ausgebildete Junction-Box wird diese Abschattung reduziert und so der Wirkungsgrad des Solarmoduls erhöht.

Der Ausdruck "transparent" bedeutet im Sinne der Erfindung insbesondere sichtbares Licht durchlassend. Transparentes Material bedeutet, dass das Material die Eigenschaft aufweist, elektromagnetische Wellen in einem definierten Wellenlängenbereich durchzulassen. Die elektromagnetischen Wellen umfassen Licht, d.h. elektromagnetische Wellen in einem für den Menschen sichtbaren Spektralbereich. Unter sichtbarer Strahlung werden Wellenlängen von 380 nm bis 780 nm Wellenlänge verstanden, bezogen auf die Helligkeitsempfindlichkeit des menschlichen Auges. Nur etwa die Hälfte der solaren Strahlungsenergie ist sichtbares Sonnenlicht. Sonnenlicht umfasst einen ultravioletten Spektralbereich, den sichtbaren Spektralbereich und nahes und mittleres Infrarot. Das optisch transparente Material kann aber muss nicht farblos sein. Bevorzugt ist es farblos.

Die Junction-Box weist bevorzugt mindestens einen ersten Kontakt, der mit den Solarzellen elektrisch verschaltet ist, und mindestens einen zweiten Kontakt auf, der geeignet ist, von einer komplementären Struktur kontaktiert zu werden. Alternativ oder zusätzlich bevorzugt weist die mindestens einen elektrischen Anschluss, mindestens eine Diode und/oder mindestens eine Bypass-Diode auf.

In einer bevorzugten Ausführungsform weist das Material des Gehäuses im definierten Wellenlängenbereich einen Lichttransmissionsgrad im Bereich von durchschnittlich über 80 %, bevorzugt über 70 %, bevorzugter über 60 % auf, gemessen nach DIN EN 1013:2015-03.

Der Lichttransmissionsgrad oder die Lichtdurchlässigkeit gibt an, welcher Anteil der sichtbaren Strahlung bei senkrechter Einstrahlung durch ein Material hindurchtritt. Die Lichtdurchlässigkeit kann neben der Wahl des Materials weiterhin durch eine Materialdicke, Reflexion und Beschichtung beeinflusst werden.

Bevorzugt ist das Material des Gehäuses aus Glas und/oder einem Kunststoff gebildet. Bevorzugter ist das Material des Gehäuses aus einem amorphen Polymer gebildet.

In einer bevorzugten Ausführungsform ist das Material des Gehäuses aus Glas gebildet. Beispielsweise ist das Glas ein Silikatglas. Silikatgläser weisen insbesondere eine Transparenz zwischen 170 nm und 5000 nm auf, dies schließt den sichtbaren Bereich vollständig, den UV-Bereich und Infrarot-Bereich teilweise ein.

Alternativ oder zusätzlich bevorzugt ist das Material des Gehäuses ein Kunststoff. Kunststoff hat den Vorteil Glas gegenüber, dass es bruchsicherer ist. Bevorzugter ist der Kunststoff ein amorphes Polymer. Bei amorphen Polymeren sind die Polymerketten räumlich ungleichmäßig verteilt. Die Kunststoffe aus amorphen Polymeren eignen sich daher als transparentes Material. Alternativ bevorzugt eignen sich auch teilkristalline Polymere als Material des Gehäuses insbesondere, wenn ihnen ein Nukleierungsmittel zugesetzt ist. Der Zusatz von Nukleierungsmitteln, die als Clarifier bezeichnet werden, sind Transparenzverstärker, die dafür sorgen, dass die Polymere transparent sind. Beispiele für Transparenzverstärker sind (aktivierte) Azodicarbonsäurediamid, p-Toluolsulfohydrazit, 2,4,6-Trihydrazino-1,3,5-triazin, p-Toluolsulfonylsemicarbazid oder 5-Pheyl-tetrazol. Beispiele für transparent ausbildbare teilkristalline Polymere sind Polyethylen, Polypropylen, Polyvinylidenfluorid oder Polyethersulfon.

In einer bevorzugten Ausführungsform ist das Material des Gehäuses ausgewählt aus der Gruppe, bestehend aus Glas, Polystyrol, Polymethylmethacrylat, Polycarbonat, Polyvinylchlorid, Glycol modifiziertes Polyethylenterephthalat, Polyphenoloxid, Polyethylen, Polypropylen, Polyvinylidenfluorid, amorphes Polyethylenterephtalat, thermoplastisches Polyester, Polyetherimid und/oder Polysulfon. Alle Materialien weisen eine für das Bifazial-Solarmodul geeignete Transparenz auf.

Bevorzugt ist das Material des Gehäuses aus Polystyrol gebildet. Als Polystyrol ist Styrolacrylnitril bevorzugt. Festes amorphes Polystyrol ist hart, aber schlagempfindlich. Es ist wenig wärmebeständig, ab 55°C setzt eine Beschleunigung der Alterung ein, weshalb es nur bis 70°C einsetzbar ist. Polystyrol ist zwar beständig gegen Wassereinwirkung, verrottet jedoch, wenn es UV-Strahlung ausgesetzt ist. Es ist daher insbesondere im Außenbereich einsetzbar, wenn es weiterhin einen UV-Schutz aufweist.

Bevorzugt ist das Material des Gehäuses aus Polymethylmethacrylat, auch Acrylglas genannt, gebildet. Polymethylmethacrylat ist schon aufgrund seiner chemischen Zusammensetzung UV-beständig und kann daher im Außenbereich eingesetzt werden. Der Temperatureinsatzbereich von Polymethylmethacrylat in transparenter Ausführung reicht von -40°C bis +90°C. Polymethylmethacrylat weist eine sehr hohe Lichtdurchlässigkeit auf, die sogar die Lichtdurchlässigkeit von anorganischem Glas übertrifft. Polymethylmethacrylat weist eine harte, sehr kratzunempfindliche Oberfläche auf, ist jedoch aufgrund der Sprödigkeit des Kunststoffs empfindlich in Bezug auf das Bruchverhalten.

Bevorzugt ist das Material des Gehäuses aus Polycarbonat gebildet. Polycarbonat zeichnet sich vor allem wegen seiner sehr hohen Schlagfestigkeit und seinem sehr guten Bruchverhalten auf. Polycarbonat ist jedoch recht kratzempfindlich und nicht UV-stabil. Es ist daher insbesondere im Außenbereich einsetzbar, wenn es weiterhin einen UV-Schutz aufweist. Ein Vorteil von Polycarbonat ist jedoch sein Temperatureinsatzbereich, der sich von -100°C bis zu +120°C erstreckt. Zudem ist Polycarbonat schwer entflammbar.

Bevorzugt ist das Material des Gehäuses aus Polyvinylchlorid ausgebildet, insbesondere Hart-Polyvinylchlorid. Polyvinylchlorid ist schlagzäh und weist ein ausreichendes Bruchverhalten und eine ausreichende Kratzfestigkeit auf. Hart-Polyvinylchlorid ist nicht frostbeständig und weist einen vergleichsweise geringen Temperatureinsatzbereich von 0°C bis +60°C auf und ist nicht UV-beständig, so dass Polyvinylchlorid mit einem UV-Schutz versehen sein sollte, damit es im Außenbereich eingesetzt werden kann. Vorteile von transparentem Polyvinylchlorid sind eine sehr gute chemische Beständigkeit und seine schwere Entflammbarkeit.

Bevorzugt ist das Material des Gehäuses aus Glycol modifiziertem Polyethylenterephthalat gebildet. Glycol modifiziertes Polyethylenterephthalat ist nicht UV- und witterungsbeständig, aber transparent, schlagzäh, bruchfest und brandsicher. Darüber hinaus weist es eine sehr hohe Chemikalienbeständigkeit auf und ist unempfindlich gegen tiefe Temperaturen. Der Temperatureinsatzbereich von Glycol modifiziertem Polyethylenterephthalat liegt zwischen -40°C und +65°C. Im Außenbereich einsetzt, sollte es einen UV-Schutz aufweisen.

Bevorzugt ist das Material des Gehäuses aus Polyphenylenoxid, auch als Polyphenylenether bezeichnet, gebildet. Polyphenylenether zeichnen sich durch Heißwasserbeständigkeit, hohe Schlagzähigkeit und hohen Brandschutz aus. Polyphenylenoxid kann weiterhin als Blend mit Polystyrol eingesetzt werden.

Bevorzugt ist das Material des Gehäuses aus Polyethylen gebildet. Eine maximale Dauergebrauchstemperatur liegt je nach Typ bei etwa 60 bis 85 °C. Polyethylen weist gute elektrische Isoliereigenschaften und eine gute chemisch Beständigkeit auf. Polyethylen ist jedoch nicht UV-beständig und muss zum Einsatz im Außenbereich mit einem UV-Schutz versehen sein.

Bevorzugt ist das Material des Gehäuses aus Polypropylen gebildet. Polypropylen ist härter, fester und thermisch höher belastbar als Polyethylen. Die maximale Dauereinsatztemperatur liegt bei etwa 100 °C. Polypropylen ist jedoch nicht UV-beständig und muss zum Einsatz im Außenbereich mit einem UV-Schutz versehen sein.

Bevorzugt ist das Material des Gehäuses aus Polyvinylidenfluorid gebildet. Polyvinylidenfluorid weist eine gute thermische Beständigkeit und ist UV-beständig.

Bevorzugt ist das Material des Gehäuses aus amorphem Polyethylenterephtalat gebildet. Amorphes Polyethylenterephthalat weist eine gute Schlagzähigkeit und Dimensionsstabilität auf. Seine Einsatzgrenzen liegen zwischen -40 bis + 60 °C.

Bevorzugt ist das Material des Gehäuses aus thermoplastischem Polyester gebildet. Bevorzugt ist der thermoplastische Polyester Polyethylenterephthalat. Das teilkristalline, unverstärkte Polyethylenterephthalat verfügt über eine hohe mechanische Festigkeit und Härte und zeigt aufgrund des niedrigen thermischen Ausdehnungskoeffizienten und der geringen Feuchtigkeitsaufnahme eine gute Dimensionsstabilität.

Bevorzugt ist das Material des Gehäuses aus Polyetherimid gebildet. Polyetherimid weist einen bernsteinfarbenen oder goldfarbenen Farbton auf. Polyetherimid ist inhärent flammwidrig bei geringer Rauchentwicklung und weist eine relativ hohe Festigkeit auf. Zudem ist Polyetherimid wasserbeständig und UV-beständig.

Bevorzugt ist das Material des Gehäuses aus Polysulfon gebildet. Polysulfon weist einen bernsteinfarbenen oder gelben Farbton auf. Polysulfon weist eine relativ gute mechanische Festigkeit und Steifigkeit auf und kann im Temperaturbereich zwischen -50°C bis +180 °C eingesetzt werden. Polysulfon weist eine hervorragende Dimensionsstabilität, sehr gute Hydrolysebeständigkeit und Strahlenbeständigkeit auf. Durch UV-Strahlen unterhalb von 320 nm wird Polysulfon abgebaut und sollte daher für Außenanwendungen mit einem UV-Schutz versehen werden.

Wie vorstehend beschrieben, muss das Material des Gehäuses beständig gegenüber UV-Strahlen sein, um im Außenbereich verwendet werden zu können. Sollte das Material nicht inhärent UV-beständig sein, so muss es hierfür mit einem UV-Schutz versehen werden. Eine Möglichkeit zur Realisierung des UV-Schutzes ist, das Material des Gehäuses mit einem UV-Stabilisator zu versehen. Eine weitere Möglichkeit ist, das Material des Gehäuses weiterhin mit einer Beschichtung zu versehen, die den UV-Stabilisator enthält. Zum Schutz insbesondere eines Kunststoffs als Material des Gehäuses vor unerwünschten Alterungseinflüssen werden UV-Stabilisatoren wie beispielsweise Antioxidantien, Antiozonantien, Lichtschutzmittel eingesetzt, die auch als Radikalfänger wirken können. Der UV-Stabilisator kann ein UV-Absorber oder ein Inhibitor sein.

UV-Absorber funktionieren nach dem Prinzip der Lichtabsorption entsprechend dem Lambert-Beerschen-Gesetz. Die absorbierte Menge an UV-Strahlung ist dabei eine Funktion der Dicke des durchstrahlten Körpers und der Stabilisatorkonzentration. Sie wird als thermische Energie wieder abgegeben. Wenn der UV-Absorber als Inhibitor wirkt, absorbiert er hingegen keine UV-Strahlung, sondern wirkt dort, wo der durch UV-Strahlen verursachte Materialabbau stattfindet, als Wasserstoffdonator. Ein Wasserstoffatom wird dabei an ein Peroxidradikal abgegeben. Dabei werden stabile Radikale gebildet, so dass der Inhibitor als Radikalfänger wirkt.

Bevorzugt enthält das Material des Gehäuses einen UV-Stabilisator. Der UV-Stabilisator ist eine chemische Verbindung, die dem Polymer, das als Gehäusematerial vorgesehen ist, als Zusatz zugefügt ist und als Schutz gegen Alterung durch UV-Strahlung wirkt. Beispiele für den UV-Stabilisator sind beispielsweise Benzotriazole wie 2,4-Di-tert-butyl-6-(5-chlorbenzotriazol-2-yl)phenol, Benzophenone, Cyanoacrylate, Triazine wie Phenyltriazine und HALS (Hindered Amine Light-Stabilisors). Die sterisch gehinderten Amine (HALS) basieren auf 2,2,6,6-Tetramethylpiperidin.

In einer bevorzugten Ausführungsform ist das Material des Gehäuses mit einer UV-absorbierenden im Wellenlängenbereich von 380nm bis 1100nm optisch transparenten Beschichtung beschichtet. Dadurch kann dem Alterungsprozess des Gehäuses bei der Verwendung im Außenbereich vorgebeugt werden. Bevorzugt ist eine Außenseite des Gehäuses mit der Beschichtung versehen. Die UV-absorbierende im Wellenlängenbereich von 380nm bis 1100nm optisch transparente Beschichtung kann auf dem Gehäuse in Form eines Lacks oder Klebstoffs bevorzugt Lacks aufgebracht sein. Der Lack ist bevorzugt ein Klarlack, der mindestens einen farblosen UV-Stabilisator aufweist, der keiner Farbveränderung unterliegt. In dem Lack kann nanoskaliges Titandioxid als anorganischer UV-Stabilisator eingesetzt werden. Im Gegensatz zu als Pigment eingesetzten, gröberen Titandioxid sind sehr feine Titandioxid-Typen transparent. Sie verursachen keine Trübung des Lacks. Ferner kann die Beschichtung, die vorstehend genannten UV-Stabilisatoren aufweisen.

Bevorzugt weist die Junction-Box weiterhin ein im Wellenlängenbereich von 380nm bis 1100nm optisch transparentes Füllmaterial auf, das in dem Gehäuse angeordnet ist. Dadurch ist ein zusätzlicher Schutz gewährleistet, so dass keine oder zumindest eine signifikant verminderte Feuchtigkeitsmenge an elektrische Kontakte dringen kann, die sich in der Junction-Box befinden. Dadurch kann deren Korrosion verhindert oder zumindest verzögert werden. Mittels der Transparenz des Füllstoffs kann weiterhin eine Reduzierung des Wirkungsgrads aufgrund Intransparenz verhindert werden. Bevorzugt ist das optisch transparente Füllmaterial ein klares, im Sinne der vorliegenden Definition optisch transparentes Silikon.

In einer bevorzugten Ausführungsform weist das Bifazial-Solarmodul weiterhin ein Dichtungsmittel auf, das zwischen dem Frontseitenverkapselungselement und dem Rückseitenverkapselungselement derart angeordnet ist, dass es das Gehäuse umgibt und/oder zwischen dem Gehäuse und dem Frontseitenverkapselungselement angeordnet ist. Dadurch kann ein Eindringen von Feuchtigkeit an sich in der Junction-Box befindende elektrische Kontakte verhindert oder zumindest reduziert werden. Das Dichtungsmittel ist bevorzugt aus einem im Wellenlängenbereich von 380nm bis 1100nm optisch transparenten Dichtungsmittel-Material ausgebildet, beispielsweise in Form von transparentem Silikon.

Das Bifazial-Modul kann das im Wellenlängenbereich von 380nm bis 1100nm optisch transparentes Füllmaterial in der Junction-Box und/oder als das Dichtungsmittel aufweisen.

Nachfolgend wird die Erfindung unter Bezugnahme auf Zeichnungen detaillierter erläutert. Es zeigen schematisch und nicht maßstabsgerecht
Fig. 1 eine Querschnittsansicht eines Bifazial-Solarmodul-Abschnitts gemäß einer ersten Ausführungsform;
Fig. 2 eine Querschnittsansicht eines Bifazial-Solarmodul-Abschnitts gemäß einer zweiten Ausführungsform; und
Fig. 3 eine Querschnittsansicht eines Bifazial-Solarmodul-Abschnitts gemäß einer dritten Ausführungsform.

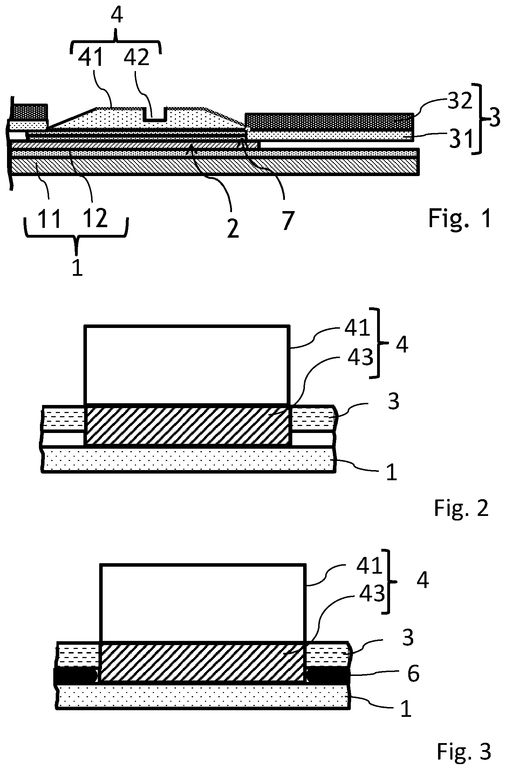

Fig. 1 eine Querschnittsansicht eines Bifazial-Solarmodul-Abschnitts gemäß einer ersten Ausführungsform. Das Bifazial-Solarmodul weist das Frontseitenverkapselungselement 1 auf, das eine Glasplatte 11 und eine Einbettungspolymerschicht 12 umfasst, die beispielsweise Ethylenvinylacetat aufweist. Auf der Einbettungspolymerschicht 12 ist eine Solarzelle 2 angeordnet, die mittels Zellverbindern (aufgrund der Abschnitts-Darstellung nicht gezeigt) mit weiteren Solarzellen (nicht gezeigt) zu Zellstrings (nicht gezeigt) verschaltet ist. Das Bifazial-Solarmodul weist weiterhin ein Rückseitenverkapselungselement 3 auf, das ein Einbettungspolymer 32 wie beispielsweise Ethylenvinylacetat und eine Rückseitenverkapselungsstruktur 31 aufweist. Das Bifazial-Solarmodul weist weiterhin eine Junction-Box 4 auf, dessen Gehäuse 41 aus einem im Wellenlängenbereich von 380nm bis 1100nm optisch transparenten Material ausgebildet ist. Die Junction-Box 4 ist in dieser Ausführungsform als Flachstecker ausgebildet, der das Rückseitenverkapselungselement 3 nicht oder nur geringfügig überragt und in das Rückseitenverkapselungselement 3 teilweise eingebettet beispielsweise einlaminiert ist. Die Junction-Box 4 weist eine Aufnahme 42 zur Aufnahme einer komplementären Kontaktstruktur (nicht gezeigt) auf. Optional ist unter der Junction-Box 4 eine Schicht 7, die beispielsweise aus dem Einbettungspolymer wie beispielsweise Ethylenvinylacetat besteht, angeordnet. Die Junction-Box 4 ist auf der optionalen Schicht 7 oder direkt auf der Solarzelle 2 angeordnet.

Fig. 2 zeigt eine Querschnittsansicht eines Bifazial-Solarmodul-Abschnitts gemäß einer zweiten Ausführungsform. Das in Fig. 2 gezeigte Bifazial-Solarmodul entspricht dem in Fig. 1 gezeigten Bifazial-Solarmodul mit dem Unterschied, dass die Junction-Box 4 nicht in das Rückseitenverkapselungselement 3 einlaminiert ist und eine andere Form und Gestalt aufweist, so dass sie aus dem Rückseitenverkapselungselement 3 herausragt und in dem Gehäuse 41 ein Füllmaterial 43 angeordnet ist. Als das Füllmaterial 43 ist insbesondere ein Füllmaterial gewählt, das im Wellenlängenbereich von 380nm bis 1100nm optisch transparent ist. Der Übersichtlichkeit halber sind die Glasplatte 11, die Einbettungspolymerschicht 12, die Solarzelle 2, das Einbettungspolymer 32 und die Rückseitenverkapselungsstruktur 31 in Fig. 2 nicht dargestellt.

Fig. 3 zeigt eine Querschnittsansicht eines Bifazial-Solarmodul-Abschnitts gemäß einer dritten Ausführungsform. Das in Fig. 3 gezeigte Bifazial-Solarmodul entspricht dem in Fig. 2 gezeigten Bifazial-Solarmodul mit dem Unterschied, dass es weiterhin ein Dichtungsmittel 6 aufweist, das zwischen dem Frontseitenverkapselungselement 1 und dem Rückseitenverkapselungselement 3 derart angeordnet ist, dass es das Gehäuse 41 umgibt und das das Gehäuse 41 das Füllmaterial 43 nur optional aufweist. In einer nicht dargestellten, alternativen Abwandlung ist das Dichtungsmittel 6 alternativ oder kumulativ auch zwischen Frontseitenverkapselungselement 1 und dem umlaufenden Rand des Gehäuses 41 angeordnet.

### Bezugszeichenliste:

1 Frontseitenverkapselungselement
11 Glasplatte
12 Einbettungspolymer
2 Solarzellen
3 Rückseitenverkapselungselement
31 Rückseitenverkapselungsstruktur
32 Einbettungspolymer
4 Junction-Box
41 Gehäuse
42 Aufnahme
43 Füllmaterial
6 Dichtungsmittel
7 Schicht

## Patentansprüche

1. Bifazial-Solarmodul mit einer Frontseitenoberfläche und einer Rückseitenoberfläche, aufweisend
- ein die Frontseitenoberfläche des Solarmoduls bildendes Frontseitenverkapselungselement (1),
- eine Mehrzahl Solarzellen (2), die elektrisch miteinander verschaltet sind,
- ein die Rückseitenoberfläche des Solarmoduls mit einer Rückseitenoberflächenebene bildendes Rückseitenverkapselungselement (3), und
- mindestens eine Junction-Box (4), die zumindest teilweise auf der Rückseitenoberfläche angeordnet ist und ein Gehäuse (41) aufweist, **dadurch gekennzeichnet, dass** das Gehäuse (41) aus einem im Wellenlängenbereich von 380nm bis 1100nm optisch transparenten Material ausgebildet ist.

2. Solarmodul nach Anspruch 1, **dadurch gekennzeichnet, dass** das Material des Gehäuses (41) im definierten Wellenlängenbereich einen Lichttransmissionsgrad im Bereich von durchschnittlich über 80 %, bevorzugt über 70 %, bevorzugter über 60 % aufweist, gemessen nach DIN EN 1013:2015-03.

3. Solarmodul nach Anspruch 1 oder 2, **dadurch gekennzeichnet, dass** das Material des Gehäuses (41) aus Glas und/oder einem Kunststoff, bevorzugt einem amorphen Polymer gebildet ist.

4. Solarmodul nach einem der vorangehenden Ansprüche, **dadurch gekennzeichnet, dass** das Material des Gehäuses (41) ausgewählt ist aus der Gruppe, bestehend aus Glas, Polystyrol bevorzugt Styrolacrylnitril, Polymethylmethacrylat, Polycarbonat, Polyvinylchlorid, Glycol modifiziertes Polyethylenterephthalat, Polyphenoloxid, Polyethylen, Polypropylen, Polyvinylidenfluorid, amorphes Polyethylenterephtalat, thermoplastisches Polyester, Polyetherimid und Polysulfon.

5. Solarmodul nach einem der vorangehenden Ansprüche, **dadurch gekennzeichnet, dass** das Material des Gehäuses (41) einen UV-Stabilisator enthält.

6. Solarmodul nach einem der vorangehenden Ansprüche, **dadurch gekennzeichnet, dass** das Material des Gehäuses (41) mit einer UV-absorbierenden im Wellenlängenbereich von 380nm bis 1100nm optisch transparenten Beschichtung beschichtet ist.

7. Solarmodul nach einem der vorangehenden Ansprüche, **dadurch gekennzeichnet, dass** die Junction-Box (4) weiterhin ein im Wellenlängenbereich von 380nm bis 1100nm optisch transparentes Füllmaterial (43) aufweist, das in dem Gehäuse (41) angeordnet ist.

8. Solarmodul nach Anspruch 7, **dadurch gekennzeichnet, dass** das optisch transparente Füllmaterial (43) Silikon ist.

9. Solarmodul nach einem der vorangehenden Ansprüche, **gekennzeichnet durch** ein Dichtungsmittel (6), das zwischen dem Frontseitenverkapselungselement (1) und dem Rückseitenverkapselungselement (3) derart angeordnet ist, dass es das Gehäuse (41) umgibt und/oder zwischen dem Gehäuse (41) und dem Frontseitenverkapselungselement (1) angeordnet ist.

## Claims

1. A bifacial solar module having a front surface and a rear surface comprising
- a front encapsulation element forming the front surface of the solar module (1),
- a plurality of solar cells (2) which are electrically interconnected,
- a backside encapsulation element (3) forming the back surface of the solar module with a rear surface plane, and
- at least one junction box (4), which is at least partially arranged on the rear surface and comprises a housing (41), **characterized in that** the housing (41) is made of an optically transparent material in the wavelength range from 380nm to 1100nm.

2. A solar module according to claim 1, **characterized in that** the material of the housing (41) in the defined wavelength range has a light transmittance in the range of on an average over 80%, preferably over 70%, more preferably over 60%, measured according to DIN EN 1013:2015-03.

3. The solar module according to claim 1 or 2, **characterized in that** the material of the housing (41) is formed of glass and/or a plastic, preferably an amorphous polymer.

4. The solar module according to one of the preceding claims, **characterized in that** the material of the housing (41) is selected from the group consisting of glass, polystyrene preferably styrene acrylonitrile, polymethyl methacrylate, polycarbonate, polyvinyl chloride, glycol modified polyethylene terephthalate, polyphenol oxide, polyethylene, polypropylene, polyvinylidene fluoride, amorphous polyethylene terephthalate, thermoplastic polyester, polyetherimide and polysulfone.

5. The solar module according to one of the preceding claims, **characterized in that** the material of the housing (41) contains a UV stabilizer.

6. The solar module according to one of the preceding claims, **characterized in that** the material of the housing (41) is coated with a UV-absorbing coating which is optically transparent in the wavelength range from 380nm to 1100nm.

7. The solar module according to one of the preceding claims, **characterized in that** the junction box (4) further comprises a filling material (43) which is optically transparent in the wavelength range from 380nm to 1100nm and which is arranged in the housing (41).

8. The solar module according to claim 7, **characterized in that** the optically transparent filling material (43) is silicone.

9. The solar module according to any one of the preceding claims, **characterized by** a sealant (6) which is arranged between the front encapsulation element (1) and the back encapsulation element (3) in such a way that it surrounds the housing (41) and/or is disposed between the housing (41) and the front encapsulation element (1).

## Revendications

1. Un module solaire bifacial ayant une surface avant et une surface arrière, comprenant
- un élément d'encapsulation avant formant la surface avant du module solaire (1),
- une pluralité de cellules solaires (2) électriquement interconnectées les unes aux autres,
- un élément d'encapsulation arrière formant la surface arrière du module solaire avec un plan de surface arrière (3), et
- au moins un boîtier de jonction (4) qui est au moins partiellement disposée sur la surface arrière et comprend un boîtier (41), **caractérisé en ce que** le boîtier (41) est constitué d'un matériau optiquement transparent dans la gamme de longueurs d'onde de 380 nm à 1100 nm.

2. Le module solaire selon la revendication 1, **caractérisé en ce que** le matériau du boîtier (41) dans la gamme de longueurs d'onde définies présente un coefficient de transmission de la lumière en moyenne dans la gamme supérieure à 80%, de préférence supérieur à 70%, plus préférentiellement supérieur à 60%, mesuré selon la norme DIN EN 1013:2015-03.

3. Le module solaire selon la revendication 1 ou 2, **caractérisé en ce que** le matériau du boîtier (41) est formé de verre et/ou de plastique, de préférence de polymère amorphe.

4. Le module solaire selon l'une des revendications précédentes, **caractérisé en ce que** le matériau du boîtier (41) est choisi dans le groupe constitué par verre, polystyrène de préférence l'acrylonitrile styrène, polyméthacrylate de méthyle, polycarbonate, chlorure de polyvinyle, polyéthylène téréphtalate modifié au glycol, oxyde de polyphénol, polyéthylène, polypropylène, fluorure de polyvinylidène, polyéthylène téréphtalate amorphe, polyester thermoplastique, polyétherimide et polysulfone.

5. Le module solaire selon l'une des revendications précédentes, **caractérisé en ce que** le matériau du boîtier (41) contient un stabilisateur UV.

6. Le module solaire selon l'une des revendications précédentes, **caractérisé en ce que** le matériau du boîtier (41) est recouvert d'un revêtement optique transparent absorbant les UV dans la gamme de longueurs d'onde de 380 nm à 1100 nm.

7. Le module solaire selon l'une des revendications précédentes, **caractérisé en ce que** le boîtier de jonction (4) présente également un matériau de remplissage optiquement transparent (43) dans la gamme de longueurs d'onde de 380 nm à 1100 nm, qui est disposé dans le boîtier (41).

8. Le module solaire selon la revendication 7, **caractérisé en ce que** le matériau de remplissage optiquement transparent (43) est du silicone.

9. Le module solaire selon l'une quelconque des revendications précédentes, **caractérisé par** un produit d'étanchéité (6) qui est disposé entre l'élément d'encapsulation avant (1) et l'élément d'encapsulation arrière (3) de telle sorte qu'il entoure le boîtier (41) et/ou soit disposé entre le boîtier (41) et l'élément d'encapsulation avant (1).
